# EUROPÄISCHE PATENTSCHRIFT

(11) **EP 2 491 582 B1**
(45) Veröffentlichungstag und Bekanntmachung des Hinweises auf die Patenterteilung: **11.12.2013**
(21) Anmeldenummer: 10770711.9
(22) Anmeldetag: 11.10.2010
(51) Int. Cl.: H01L 21/48, H01L 23/498, H05K 3/40

(54) **VERFAHREN ZUM HERSTELLEN VON DURCHKONTAKTIERUNGEN**
METHOD FOR PRODUCING VIAS
PROCÉDÉ DE RÉALISATION DE TROUS MÉTALLISÉS

(30) Priorität: 22.10.2009 DE 102009050386
(43) Veröffentlichungstag der Anmeldung: 29.08.2012
(73) Patentinhaber: Mühlbauer AG, 93426 Roding (DE)
(72) Erfinder: ZOLLNER, Franz, 93489 Schorndorf (DE)
(74) Vertreter: Schneider, Andreas
(86) Internationale Anmeldenummer: PCT/EP2010/006183
(87) Internationale Veröffentlichungsnummer: WO 2011/047792

(56) Entgegenhaltungen:
- DE-A1- 1 814 805
- DE-A1- 3 046 192
- US-A- 2 900 580
- US-A1- 2005 145 608
- US-A1- 2007 171 129
- US-B2- 7 071 422

## Beschreibung

Die Erfindung betrifft ein Verfahren zum Herstellen einer Anzahl von Durchkontaktierungen zur Erzeugung von elektrisch und/oder thermisch leitfähigen Verbindungen zwischen verschiedenen Seiten eines Substrats. Darüber hinaus betrifft die Erfindung ein Substrat mit wenigstens einer derart hergestellten Durchkontaktierung.

Aus dem Stand der Technik ist es beispielsweise von der Herstellung von Transpondern für kontaktlose Karten, e-passports oder smart labels bekannt, auf einem Substrat mehrlagige Antennen herzustellen, wobei ein erster Antennenabschnitt auf einer ersten Seite des Substrats und ein zweiter Antennenabschnitt auf einer weiteren, zumeist der gegenüberliegenden Seite des Substrats angeordnet ist. Zur Herstellung einer elektrisch leitfähigen Verbindung zwischen den beiden Antennenabschnitten werden Durchkontaktierungen verwendet. Dies sind zumeist metallisierte Bohrungen im Substrat oder aber auch Niete bzw. Stifte. Die Herstellung dieser Durchkontaktierungen ist vergleichsweise aufwendig und teuer. Außerdem ist aus der Offenlegungsschrift DE1814805 ein Verfahren zum Herstellen von Durchkontaktierungen durch Leiterplatten bekannt.

Eine Aufgabe der vorliegenden Erfindung ist es, eine Technologie bereitzustellen, mit deren Hilfe Durchkontaktierungen zur Erzeugung elektrisch und/oder thermisch leitfähiger Verbindungen zwischen verschiedenen Seiten eines Substrats besonders einfach hergestellt werden können.

Diese Aufgabe wird durch ein Verfahren nach Anspruch 1 bzw. ein Substrat nach Anspruch 6 gelöst. Vorteilhafte Ausführungen der Erfindung sind in den Unteransprüchen angegeben.

Das erfindungsgemäße Verfahren umfaßt die Schritte: Einbringen wenigstens einer elektrisch und/oder thermisch leitfähigen Folie in eine durchgehende, die verschiedenen Seiten des Substrats miteinander verbindende Öffnung und Befestigen von Bereichen der wenigstens einen Folie in der Nähe der Ränder der Öffnung auf den Oberflächen der Substratseiten.

Eine Kernidee der Erfindung ist es, als Ersatz für eine Niete bzw. einen Stift eine elektrisch und/oder thermisch leitfähige Folie zur Erzeugung einer Durchkontaktierung zu verwenden.

Unter einer Folie wird dabei ein blattförmiges Element mit einer geringen Dicke verstanden, die vorzugsweise zwischen etwa 10 und 100 µm liegt. Für die Verwendung als Durchkontaktierung ist die Folie vorzugsweise streifenförmig zugeschnitten. Die Folie liegt in der Öffnung vorzugsweise einlagig ein. Dicke, Form sowie Ein- oder Mehrlagigkeit der Folie werden entsprechend den Anforderungen an die Leitfähigkeit einerseits und die Abmessungen und die Verwendung der Öffnung andererseits ausgewählt.

Bei den Bereichen der Folie, die auf beiden Seiten aus der Öffnung hinausragen, handelt es sich vorzugsweise um die Endstücke des Folienstreifens. Diese Bereiche sind in der Nähe der Ränder der Öffnung auf den Oberflächen der Substratseiten befestigt und bilden zugleich die Anschlußkontakte für leitfähige Strukturen, wie beispielsweise Drähte, gedruckte Leiterbahnen, Antennen, Chips oder Chip-Module, die mit den Anschlußkontakten verbunden, beispielsweise angelötet oder angeschweißt werden können.

Als Substrat im Sinne der Erfindung werden auch einzelne Schichten (layer) eines schichtweise aufgebauten Bauelements, wie beispielsweise einer mehrlagigen Karte oder dergleichen verstanden.

Aufgrund der vergleichsweise geringen Dicke der Folien werden einerseits nur sehr kleine Öffnungen benötigt. Andererseits ist es aufgrund der geringen Dicke der Folien möglich, die Folien in Öffnungen einzubringen, die anderen Zwecken dienen. So hat es sich beispielsweise als besonders vorteilhaft erwiesen, mit Hilfe des erfindungsgemäßen Verfahrens eine Anzahl von Durchkontaktierungen in der Öffnung einer Ausgleichsschicht herzustellen, wie sie bei mehrlagigen ChipKarten oder dergleichen zum Einsatz kommt, um einen Dickenausgleich vorzunehmen bzw. um zu verhindern, daß sich die Positionen von Leiterbahnstrukturen bzw. Chip-Modulen noch an der Oberfläche der mehrlagigen Karte abbilden. Mit anderen Worten hat es sich als besonders vorteilhaft erwiesen, die erfindungsgemäßen Durchkontaktierungen vorzugsweise in Öffnungen von Ausgleichs- bzw. Kompensationsschichten herzustellen. Daher ist es bei Anwendung der vorliegenden Erfindung nicht zwingend notwenig, zusätzliche, die verschiedenen Seiten des Substrats miteinander verbindende Öffnungen zu schaffen. Statt dessen können bereits vorhandene Öffnungen für die Erstellung der Durchkontaktierungen verwendet werden. Selbstverständlich ist es möglich, die erfindungsgemäße Durchkontaktierungstechnik in einer Mischform anzuwenden, beispielsweise dergestalt, daß eine Anzahl von Durchkontaktierungen in einer bereits vorhandenen Öffnung und eine Anzahl weiterer Durchkontaktierungen in zu diesem Zweck hergestellten Öffnungen erzeugt werden.

Mit der Erfindung wird eine Technologie geschaffen, mit der Durchkontaktierungen auf besonders einfache Art und Weise und damit wesentlich preiswerter als bisher hergestellt werden können.

Die vorliegende Erfindung ist vor allem in der Halbleiterindustrie anwendbar. Insbesondere ist sie bei der Herstellung von Durchkontaktierungen für Antennen für Transponder einsetzbar. Unter einem Transponder wird dabei ein Gerät zur drahtlosen Kommunikation verstanden, das eingehende Signale aufnimmt und automatisch beantwortet. Der Transponder umfaßt einen Chip, insbesondere einem RFID (Radio Frequency Identification)-Chip, und eine Antenne, die mit dem erfindungsgemäßen Verfahren hergestellt werden kann. Derartige Transponder werden als sogenannte RFID-Inlays (bzw. RFID-Inlets) zur drahtlosen Kommunikation beispielsweise in kontaktlosen Karten, e-passports, Smart Labels und dergleichen eingesetzt. Der Begriff Chip bezeichnet dabei ein elektronisches Bauelement mit wenigstens einer integrierten elektronischen Schaltung, wobei in dem vorliegenden Text unter dem allgemeinen Begriff "Chip", sofern nicht ausdrücklich anders angegeben, sowohl ungehäuste Silizium-Chips ("bare dice"), als auch Chipmodule verstanden werden.

Vorteilhafte Ausführungen der Erfindung sind in den Unteransprüchen angegeben und werden im Zusammenhang mit Ausführungsbeispielen der Erfindung nachfolgend anhand der Zeichnungen näher erläutert. Hierbei zeigen:
- Fig. 1: eine perspektivische Darstellung einer Ausgleichsschicht mit Öffnung für ein Chip-Modul,
- Fig. 2: einen Schnitt durch eine mehrschichtige Karte in Explosionsdarstellung,
- Fig. 3: einen Schnitt durch eine mehrschichtige Karte im Laminierten Zustand,
- Fig. 4: eine Detailansicht einer Durchkontaktierung,
- Fig. 5: eine Detailansicht einer weiteren DurchKontaktierung.

Sämtliche Figuren zeigen die Erfindung lediglich schematisch und mit ihren wesentlichen Bestandteilen. Gleiche Bezugszeichen entsprechen dabei Elementen gleicher oder vergleichbarer Funktion.

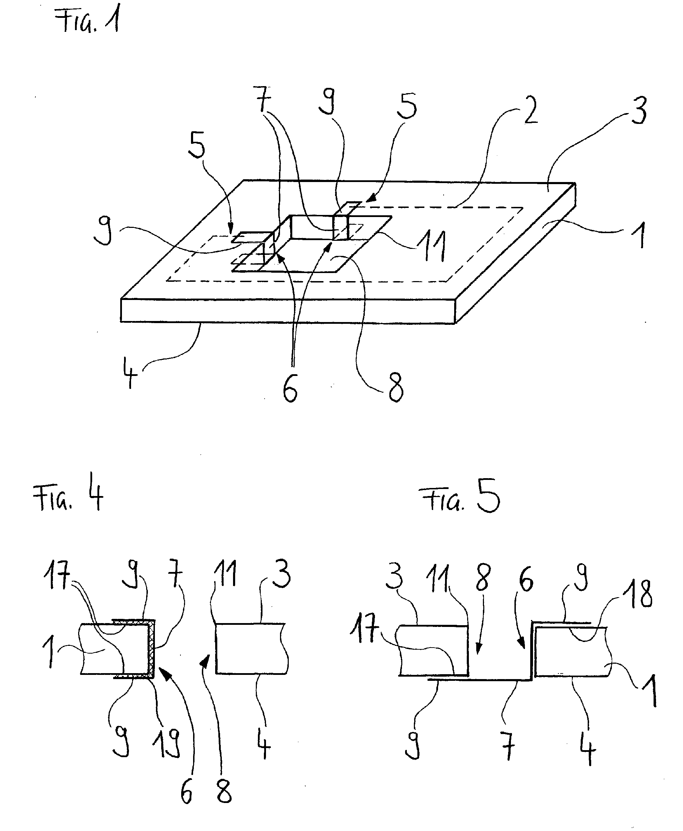

In Fig. 1 ist ein Substrat 1 mit einer zweilagigen HF-Antenne abgebildet, wobei ein erster Antennenabschnitt 2 auf der Vorderseite 3 des Substrats 1 und ein zweiter Antennenabschnitt auf der Rückseite 4 des Substrats 1 angeordnet ist, welche der Vorderseite 3 gegenüberliegt. Das mit der Antennenstruktur versehene Substrat 1 kann beispielsweise als Inlay für kontaktlose Karten, wie beispielsweise ID-Karten verwendet werden.

Der erste Antennenabschnitt 2 ist symbolisch durch eine Windung auf der Vorderseite 3 dargestellt. Der auf der Rückseite 4 angeordnete zweite Antennenabschnitt ist nicht abgebildet. Das Substrat 1 kann dabei starr oder flexibel sein. Zumeist besteht das Substrat 1 aus einem Kunststoffmaterial, wie beispielsweise Polyvinylchlorid (PVC) oder Polycarbonat (PC).

Die Enden 5 der Antennenabschnitte 2 sind mit erfindungsgemäßen Durchkontaktierungen 6 verbunden. Diese sind derart hergestellt, daß elektrisch leitfähige Folien 7 in eine durchgehende, die beiden Substratseiten 3, 4 miteinander verbindende Öffnung 8 eingebracht wurden und die Endbereiche 9 der Folien 7 in der Nähe der Ränder 11 der Öffnung 8 auf den Oberflächen der Substratseiten 3, 4 befestigt wurden.

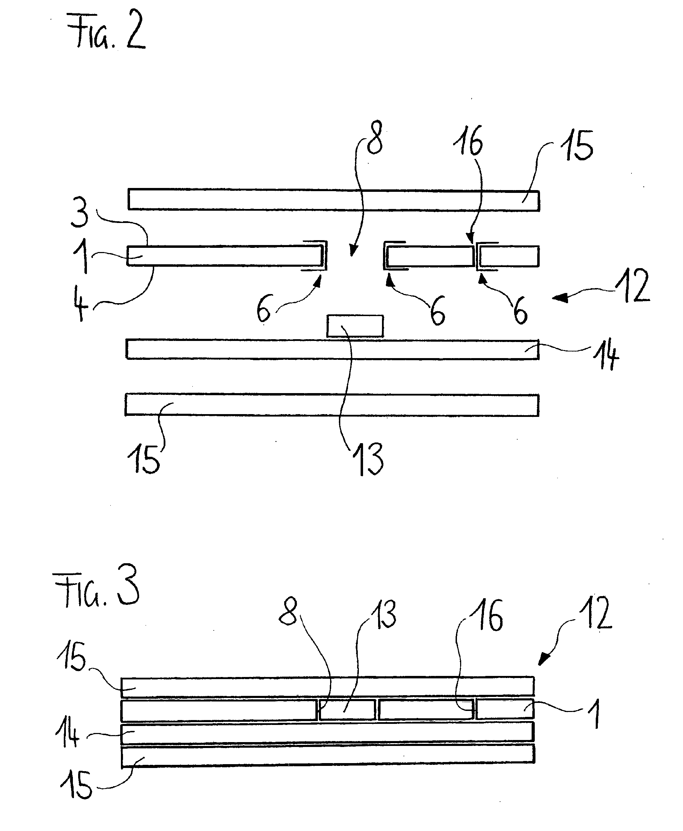

In Fig. 2 ist der Aufbau einer mehrschichtigen Chipkarte 12 abgebildet. Ein Chipmodul 13 ist auf einer Chipträgerschicht 14 angeordnet. Zum Höhenausgleich ist auf der Chipträgerschicht 14 eine Ausgleichsschicht 1 vorgesehen mit einer Öffnung 8 für das Chipmodul 13. Oberhalb der Ausgleichsschicht 1 und unterhalb des Chipträgerschicht 14 sind Deckschichten 15 vorgesehen. Alle Schichten werden zur Fertigstellung der Chipkarte 12 laminiert. Die fertige Karte 12 ist in Fig. 3 dargestellt, wobei vereinfacht lediglich vier Schichten dargestellt sind. Übliche mehrschichtige Karten bestehen zumeist aus mehr als zehn Schichten.

In der Ausgleichsschicht 1 sind insgesamt drei Durchkontaktierungen 6 vorgesehen, und zwar zwei Durchkontaktierungen 6 in der Öffnung 8 für das Chipmodul 13 und eine weitere Durchkontaktierung 6 in einer entfernt von der Öffnung 8 für das Chipmodul 13 extra zur Herstellung der Durchkontaktierung hergestellten Kontaktierungsöffnung 16.

Die Öffnungen 8, 16 müssen dabei nicht geradlinig durch das Substrat 1 bzw. die Ausgleichsschicht hindurchführen. Es sind ebenfalls Öffnungen 8, 16 möglich, die schräg durch das Substrat 1 bzw. die Ausgleichsschicht verlaufen, mit anderen Worten einander nicht entsprechende Punkte an den beiden Substratoberflächen 3, 4 miteinander verbinden.

Die Form der Öffnungen 8, 16 ist beliebig. Sie kann beispielsweise kreisrund oder viereckig sein. Die Öffnungen 8, 16 sind jedoch mindestens so groß, daß die zur Herstellung der Durchkontaktierung 6 benötigte Folie 7 in die Öffnungen 8, 16 eingebracht werden kann. Vorzugsweise sind die Öffnungen 8, 16 deutlich größer und dienen ursprünglich einem weiteren Zweck, wie beispielsweise der Aufnahme eines Chipmoduls 13. Durch die geringe Dicke der Folie 7 und die ohnehin vorhandenen Toleranzen bei den Abmessungen der Öffnung 8 ist es trotz des Einbringens der Folie 7 in die Öffnung 8 noch immer möglich, die Öffnung 8 für ihren ursprünglichen Zweck zu verwenden, beispielsweise für die Aufnahme eines Chipmoduls 13.

Die Folien 7 werden in der Nähe der Ränder 11 der Öffnungen 8, 16 befestigt, wobei darunter vorzugsweise unmittelbar an den Öffnungsrand 11 angrenzender Oberflächenbereiche des Substrats 1 verstanden werden.

Aufgrund der geringen Dicke der Folie 7 ist ein Höhenausgleich (Kompensation) der Foliendicke nicht zwingend erforderlich. Auf einen Höhenausgleich kann auch deswegen in den meisten Fällen verzichtet werden, da es bei der Folie 7 um kein aktives Bauelement, wie beispielsweise ein Chipmodul handelt und daher das Risiko, daß eine Druckbelastung zu einer Beschädigung oder Zerstörung der Folie 7 führt, sehr gering ist.

Die Folie 7 kann somit nach dem Durchtritt durch die Öffnung 8, 16 jeweils in die gleiche Richtung umgeschlagen werden, so daß sie auf entsprechend übereinanderliegenden Oberflächenbereichen 17 des Substrats 1 anliegt. Ein Beispiel einer solchen Befestigung ist in Fig. 4 dargestellt. Bei kritischen Applikationen bzw. wenn es das Schaltungsdesign erfordert, kann die Folie 7 jedoch auch in einer anderen Richtung umgeschlagen werden, so daß die zu befestigenden Bereiche der Folie 7 auf nicht übereinanderliegenden Oberflächen 17, 18 befestigt werden, vgl. Fig. 5. Der Ausgleich der Foliendicke wird dadurch gegenüber der in Fig. 4 abgebildeten Variante einfacher.

Das Befestigen der Kontaktanschlüsse erfolgt in einer bevorzugten Ausführungsform der Erfindung durch ein Verkleben der Endbereiche 9 der Folie 7 auf den Oberflächen 3, 4 des Substrats 1. Hierbei kann auf die Folie 7 in diesen Bereichen 9 ein Klebstoff aufgetragen werden, wobei sich dabei vorzugsweise um einen leitfähigen Klebstoff handelt. Die Folie 8 kann in diesen Bereichen 9 jedoch auch als selbstklebende Folie ausgebildet sein.

Alternativ dazu kann es sowohl bei der Verwendung eines aufzutragenden Klebstoffes, als auch bei der Verwendung einer Klebefolie vorgesehen sein, daß nicht nur die an den Oberflächen der Substratseiten 2, 3 zu befestigenden Bereiche 9 der Folie 7, sondern die gesamte Folie 7 mit Klebstoff versehen ist. Mit anderen Worten wird eine Seite der Folie 7 vollständig mit einem Klebstoff versehen bzw. es handelt sich bei der Folie 7 von vornherein um eine Klebefolie, deren eine Seite vollständig mit Klebstoff 19 versehen ist, vgl. Fig. 4.

Ist eine Seite der Folie 7 vollständig mit Klebstoff 19 versehen, dann ist es möglich, die Folie 7 nicht nur an den Befestigungsbereichen 17, 18 außerhalb der Öffnung 8, 16, sondern auf ihrer gesamten Länge zu verkleben, also auch im Inneren der Öffnung 8, 16. Erfolgt eine solche Verklebung im Inneren der Öffnung 8, 16, so kann damit verhindert werden, daß die Folie 7 bei einer späteren Montage des Substrats 1 beschädigt wird, beispielsweise dann, wenn ein Chipmodul 13 in die Öffnung 8 eingeführt wird.

Die Gesamtdicke der Folie 7 beträgt vorzugsweise mindestens 30 µm und höchstens 70 µm. In einer besonders bevorzugten Ausführungsform der Erfindung beträgt die Gesamtdicke der Folie 30 µm, wobei es sich in diesem Fall um eine Klebefolie handelt, die aus einer 25 µm dicken Metallfolie besteht, welche auf einer Seite mit einem 5 µm dicken Klebstoffüberzug versehen ist. Die Mindestdicke der Metallfolie beträgt nach heutigem Stand der Technik bei Kupfer 18 µm, um ein Einreißen zu vermeiden. Die Klebstoffschicht kann so dünn wie möglich gewählt werden, beispielsweise 2 bis 5 µm, so daß sich bei der Verwendung von Kupfer eine Mindestdicke der Folie 7 von etwa 20 µm ergibt. Die maximale Dicke der Folie 7 ist von der konkreten Anwendung und den Prozeßparametern bei der Weiterverarbeitung des Substrats 1 abhängig.

Besonders gute Ergebnisse werden mit Folien 7 aus Kupferoder Aluminiummaterial erzielt. Andere leitfähige Materialien können ebenso eingesetzt werden, wir mit leitfähigem Material beschichtete Folien.

Alternativ zu einem Verkleben kann das Befestigen der Folie 7 an dem Substrat 1, insbesondere am Rand 11 der Öffnung 8, 16, auch dadurch erfolgen, daß die Folie 7 an den Substratoberflächen 3, 4 "anhaftet". Insbesondere bei der Verwendung von Substraten 1 aus Kunststoffmaterialien und Folien 7, die eine rauhe, strukturierte Oberfläche aufweisen, kann eine derartige Verbindung hergestellt werden, wenn die rauhe Oberfläche mit dem Kunststoffsubstrat 1 unter Wärme "verbacken" wird. Hierzu wird das Kunststoffsubstrat 1 über den Glaspunkt des Kunststoffes erwärmt, wodurch der Kunststoff leicht verformbar wird und zu fließen anfängt, so daß eine formschlüssige Verbindung mit der strukturierten Folienoberfläche entsteht. Eine alternative Erhöhung des Drucks zum Erreichen des Glaspunktes ist unvorteilhaft, da dies zu Beschädigungen des Materials führen kann.

Je nach dem gewünschten Design der auf der Vorderseite 3 und der Rückseite 4 des Substrats 1 anzuordnenden Leiterstrukturen (z. B. Antennen 2) können in einer Öffnung 8 auch zwei oder mehr Durchkontaktierungen 6 eingebracht werden. Im Falle von zwei Durchkontaktierungen 6 kann beispielsweise auf jeder Seite 3, 4 des Substrats 1 eine Wicklung einer Antenne vorgesehen sein, vgl. Fig. 1, während bei drei Durchkontaktierungen 6 eine Mehrzahl von Antennenwindungen auf den einzelnen Substratseiten 3, 4 möglich sind, vgl. Fig. 2.

Bei den mit den Durchkontaktierungen 6 verbundenen Strukturen auf den Seiten 3, 4 des Substrats 1 muß es sich nicht um Antennenstrukturen 2 handeln. Statt dessen kann es sich dabei beispielsweise auch um Kontaktanschlüsse für einen Chip oder dergleichen handeln.

Auch muß es sich bei den Bereichen der Folie 7, die außerhalb der Öffnungen 8, 16 mit den Substratoberflächen 3, 4 verbunden werden, nicht zwangsweise um die Endstücke 9 des Folienstreifens 7 handeln. Die verwendete Folie 7 kann deutlich länger ausgebildet sein, so daß sie im Randbereich 11 der Öffnung 8, 16 an den Oberflächen 3, 4 befestigt und dann darüber hinaus als Leiterbahn auf der Substratoberfläche verwendet wird.

Alle in der Beschreibung, den nachfolgenden Ansprüchen und der Zeichnung dargestellten Merkmale können sowohl einzeln als auch in beliebiger Kombination miteinander erfindungswesentlich sein.

### Bezugszeichenliste

- 1: Substrat, Ausgleichsschicht
- 2: Antennenabschnitt
- 3: Vorderseite
- 4: Rückseite
- 5: Ende des Antennenabschnitts
- 6: Durchkontaktierung
- 7: Folie
- 8: Öffnung
- 9: Endbereich
- 10: (frei)
- 11: Rand
- 12: Chipkarte
- 13: Chipmodul
- 14: Chipträgerschicht
- 15: Deckschicht
- 16: Kontaktierungsöffnung
- 17: Oberflächenbereich
- 18: Oberflächenbereich
- 19: Klebstoff

## Patentansprüche

1. Verfahren zum Herstellen einer Anzahl von Durchkontaktierungen (6) zur Erzeugung von elektrisch und/oder thermisch leitfähigen Verbindungen zwischen verschiedenen Seiten (3, 4) einer Ausgleichsschicht (1) für ein schichtweise aufgebautes Bauelement (12), mit den Schritten
- Einbringen wenigstens einer elektrisch und/oder thermisch leitfähigen Folie (7) in eine zur Aufnahme eines Chipmoduls (13) vorgesehene, durchgehende, die verschiedenen Seiten (3, 4) der Ausgleichsschicht (1) miteinander verbindende Öffnung (8, 16) und
- Befestigen von Bereichen (9) der wenigstens einen Folie (7) in der Nähe der Ränder (11) der Öffnung (8, 16) auf den Oberflächen der Seiten (3, 4) der Ausgleichsschicht (1).

2. Verfahren nach Anspruch 1, wobei die zu befestigenden Bereiche (9) der Folie (7) auf nicht übereinanderliegenden Oberflächenbereichen (17, 18) der Seiten (3, 4) der Ausgleichsachicht (1) befestigt werden.

3. Verfahren nach Anspruch 1 oder 2, wobei das Befestigen durch ein Verkleben der Bereiche (9) der Folie (7) auf den Oberflächen der Seiten (3, 4) der Ausgleichssehicht (1) erfolgt.

4. Verfahren nach einem der Ansprüche 1 bis 3, wobei das Befestigen durch ein Anhaften der Bereiche (9) der Folie (7) an den Oberflächen der Seiten (3, 4) der Ausgleichsschicht (1) erfolgt.

5. Verfahren nach einem der Ansprüche 1 bis 4, wobei zur Erzeugung von zwei oder drei Durchkontaktierungen (6) zwei oder drei Folien (7) in voneinander beabstandeten Positionen in eine Öffnung (8, 16) eingebracht werden.

6. Auagleichsschicht (1) für ein schichtweise aufgebautes Bauelement (12) mit wenigstens einer Durchkontaktierung (6) zur Erzeugung einer elektrisch und/oder thermisch leitfähigen Verbindung zwischen verschiedenen Seiten (3, 4) der Ausgleichsschicht (1) dergestalt, daß in eine zur Aufnahme eines Chipmoduls (13) vorgesehene, durchgehende, die verschiedenen Seiten (3, 4) der Ausgleichsschicht (1) miteinander verbindende Öffnung (8, 16), wenigstens eine elektrisch und/oder thermisch leitfähige Folie (7) eingebracht ist und Bereiche (9) der wenigstens einen Folie (7) in der Nähe der Ränder (11) der Öffnung (8, 16) auf den Oberflächen der Seiten (3, 4) der Ausgleichsschicht (1) befestigt sind.

7. Ausgleichsschicht (1) nach Anspruch 6, wobei es sich bei der Folie (7) um eine metallische oder metallisch beschichtete Folie handelt.

8. Ausgleichsschicht (1) nach Anspruch 6 oder 7, wobei die Gesamtdicke der Folie (7) mindestens 30 µm und höchstens 70 µm beträgt.

9. Ausgleichsschicht (1) nach einem der Ansprüche 6 bis 8, wobei es sich bei der Folie (7) um eine selbstklebende Folie handelt.

## Claims

1. Method for producing a number of vias (6) in order to create electrically and/or thermally conductive connections between different faces (3, 4) of a compensating layer (1) for a structural element (12) built up in layers, comprising the steps of
- inserting at least one electrically and/or thermally conductive foil (7) into a through-opening (8, 16) that is intended for receiving a chip module (13) and connects the different faces (3, 4) of the compensating layer (1) to one another, and
- fixing areas (9) of the at least one foil (7) near the edges (11) of the opening (8, 16) on the surfaces of the faces (3, 4) of the compensating layer (1).

2. Method according to Claim 1, wherein the areas (9) of the foil (7) that are to be fixed are fixed on surface areas (17, 18) of the faces (3, 4) of the compensating layer (1) that are not lying one above the other.

3. Method according to Claim 1 or 2, wherein the fixing is performed by adhesively bonding the areas (9) of the foil (7) on the surfaces of the faces (3, 4) of the compensating layer (1).

4. Method according to one of Claims 1 to 3, wherein the fixing is performed by adhesively attaching the areas (9) of the foil (7) to the surfaces of the faces (3, 4) of the compensating layer (1).

5. Method according to one of Claims 1 to 4, wherein two or three foils (7) are inserted into an opening (8, 16) at positions spaced apart from one another in order to create two or three vias (6).

6. Compensating layer (1) for a structural element (12) built up in layers, having at least one via (6) in order to create an electrically and/or thermally conductive connection between different faces (3, 4) of the compensating layer (1) such that there is at least one electrically and/or thermally conductive foil (7) inserted into a through-opening (8, 16) that is intended for receiving a chip module (13) and connects the different faces (3, 4) of the compensating layer (1) to one another and there are areas (9) of the at least one foil (7) fixed near the edges (11) of the opening (8, 16) on the surfaces of the faces (3, 4) of the compensating layer (1).

7. Compensating layer (1) according to Claim 6, wherein the foil (7) is a metallic or metallically coated foil.

8. Compensating layer (1) according to Claim 6 or 7, wherein the total thickness of the foil (7) is at least 30 µm and at most 70 µm.

9. Compensating layer (1) according to one of Claims 6 to 8, wherein the foil (7) is a self-adhesive foil.

## Revendications

1. Procédé pour réaliser plusieurs perforations de contact (6) visant à former des liaisons électriquement et/ou thermiquement conductrices entre différentes faces (3, 4) d'une couche d'équilibrage (1) d'un composant (12) à structure stratifiée, le procédé présentant les étapes qui consistent à :
insérer au moins une feuille électriquement et/ou thermiquement conductrice (7) dans une perforation (8, 16) prévue pour reprendre un module de puce (13) et reliant l'une à l'autre les différentes faces (3, 4) de la couche d'équilibrage (1) et
fixer des parties (9) de la ou des feuilles (7) à proximité des bords (11) de l'ouverture (8, 16) sur la surface des faces (3, 4) de la couche d'équilibrage (1).

2. Procédé selon la revendication 1, dans lequel les parties (9) de la feuille (7) qui doivent être fixées sont fixées sur des parties non superposées (17, 18) de la surface des faces (3, 4) de la couche d'équilibrage (1).

3. Procédé selon les revendications 1 ou 2, dans lequel la fixation s'effectue par collage de parties (9) de la feuille (7) sur la surface des faces (3, 4) de la couche d'équilibrage (1).

4. Procédé selon l'une des revendications 1 à 3, dans lequel la fixation s'effectue par adhérence des parties (9) de la feuille (7) sur la surface des faces (3, 4) de la couche d'équilibrage (1).

5. Procédé selon l'une des revendications 1 à 4, dans lequel pour former deux ou trois perforations de contact (6), deux ou trois feuilles (7) sont placées dans une ouverture (8, 16) en des positions situées à distance mutuelle.

6. Couche d'équilibrage (1) pour composant (12) à structure stratifiée, présentant au moins une perforation de contact (6) permettant de former une liaison électriquement et/ou thermiquement conductrice entre différentes faces (3, 4) de la couche d'équilibrage (1) en plaçant au moins une feuille (7) électriquement et/ou thermiquement conductrice dans une perforation (8, 16) prévue pour reprendre un module de puce (13) et reliant l'une à l'autre différentes faces (3, 4) de la couche d'équilibrage (1) et en fixant des parties (9) de la ou des feuilles (7) sur la surface des faces (3, 4) de la couche d'équilibrage (1) à proximité des bords (11) de l'ouverture (8, 16).

7. Couche d'équilibrage (1) selon la revendication 6, dans laquelle la feuille (7) est une feuille métallique ou une feuille à revêtement métallique.

8. Couche d'équilibrage (1) selon les revendications 6 ou 7, dans laquelle l'épaisseur totale de la feuille (7) est d'au moins 30 µm et d'au plus 70 µm.

9. Couche d'équilibrage (1) selon les revendications 6 à 8, dans laquelle la feuille (7) est une feuille autocollante.
